Europäisches Patentamt

(19) European Patent Office (11) Publication number: **0 053 030**

Office européen des brevets **B1**

(12) **EUROPEAN PATENT SPECIFICATION**

(45) Date of publication of patent specification: **19.02.86** (51) Int. Cl.⁴: **H 01 L 23/36, H 01 L 23/40**

(21) Application number: **81305528.2**

(22) Date of filing: **24.11.81**

(54) Heatsink for integrated circuit device.

(30) Priority: **25.11.80 GB 8037767**

(43) Date of publication of application:
**02.06.82 Bulletin 82/22**

(45) Publication of the grant of the patent:
**19.02.86 Bulletin 86/08**

(84) Designated Contracting States:
**AT BE DE FR GB IT NL SE**

(56) References cited:
**DE-A-2 653 833**
**DE-U-7 124 853**
**GB-A-1 324 347**

(73) Proprietor: **COLUMBIA-STAVER LIMITED**
**Industrial Estate Russell Gardens**
**Wickford Essex, SS11 8QR (GB)**

(72) Inventor: **Smith, Anthony**
**10 Westwood Walk**
**Aylesbury Buckinghamshire (GB)**

(74) Representative: **Bluff, John William et al**
**c/o Lloyd Wise, Tregear & Co. Norman House**
**105-109 Strand**
**London, WC2R 0AE (GB)**

Courier Press, Leamington Spa, England.

## Description

### Field of the Invention

This invention relates to a heatsink for a semiconductor device of the type having a casing in which there is a notch providing an index for pin identification.

A particular example of such a semiconductor device is an integrated circuit device. Another example entirely analogous to integrated circuit devices in respect of packaging, i.e. encapsulation and pin-out are monolithic semiconductor devices in which, for example, an array of independent elements such as transistors are formed in a substrate. The following description will refer to integrated circuits but it will be apparent that the heatsink of the invention may be used equally with other semiconductor devices packaged to have the same external characteristics.

### Background to the Invention

Integrated circuit devices which are intended to dissipate significant amounts of power are commonly provided with a heat-conductive tab extending through the casing, e.g. a moulded plastics casing, at one long side thereof and attachable to a heatsink. One particular kind of device construction has an elongate casing with the aforementioned tab projecting at one long side and the device pins at the other. This pin configuration is commonly known as single-in-line. The pins, casing and tab may lie essentially in a common plane — the so-called single-in-line form of construction.

Many forms of heatsink are available to assist heat dissipation and for single-in-line devices it is convenient to use a heatsink formed from sheet metal provided with a surface to which the device tab is attachable in good thermal connection, e.g. by a screw or clip. The device is mounted to the heatsink so that the pins project away from the heatsink for insertion into holes of a printed circuit board. The heatsink is itself provided with one or more locating and supporting lugs or pins for insertion in holes in the board and may be shaped with a recess in its lower edge in which the body of the semiconductor device seats to locate the device with the pins projecting downwardly from the lower edge of the heatsink. In this way the pins of the heatsink and of the device attached thereto can be inserted into the board so that the combination is upstanding from the board.

A heat dissipator for encased semiconductor devices having a heat conductive tab extending therefrom is known from GB—A—1324347.

Integrated circuit devices of the single-in-line type are generally of a symmetrical construction as seen looking normal to the common plane, and the device pins are usually all of the same dimensions and pitch so that it is possible to insert the device either way round in the corresponding holes in the board. This symmetrical construction means that it is possible in mounting the device to the heatsink to reverse the required orientation of the device with respect to the heatsink. Since the latter's position on the board is fixed by its own support pin, insertion of a wrongly oriented device will result in misconnection of the device pins in the circuit, not only resulting in non-functioning of the cirucit but frequently leading to total failure of the device and possibly damage to associated components. In any event the now soldered device and secured heatsink have to be removed from the board, a time-consuming operation if repair is to be effected.

In order to identify the pins of the integrated circuit device, it is common to provide means identifying pin 1 in the conventional pin-numbering scheme. This is frequently done by putting a small notch or recess on one side of the casing at one end thereof to act as an index from which pin numbering order is identified.

The present invention is based on a realisation that this notch or recess can also be used to guide and ensure mounting of the device to the heatsink in the correct orientation.

### Summary of the Invention

According to the present invention there is provided a heatsink constructed to have mounted thereto a semiconductor device of the type having a casing in which there is a notch providing an index for pin identification, characterized in that said heatsink has a lug positioned to enter said notch when the device is correctly oriented with respect to the heatsink and to obstruct mounting of the device in a reverse orientation.

A particular application of the invention is to a heatsink for use with a semiconductor device of the kind in which a heat-conductive tab and terminal pins project in a common plane from opposite sides of the casing of the semiconductor device; and in which the notch mentioned in the preceding paragraph is located at one end of the casing. A preferred construction of the heatsink to receive such a semiconductor device comprises a recess in a lower edge portion of the heatsink to receive and locate the device casing with the aforementioned notch adjacent a side edge of the recess, and with the terminal pins of the device projecting beyond the lower edge of the heatsink. The heatsink further has an area extending from the base of the recess and contactable with the tab of the semiconductor device to be in area contact therewith. Means is provided for use in securing the tab to the heatsink. For the correct orientation of the device, the abovementioned lug projects into the recess from the side edge thereof adjacent the casing notch.

The lug is preferably integral with the portion of the recess defining this side edge. Such a structure may be realised with sheet metal or extruded heatsinks.

The heatsink preferably also comprises means, such as one or more pins, depending below the lower edge portion of the heatsink for securing the heatsink to a printed circuit board independently of a device mounted to the heatsink. The device is, of course, secured to the board by its terminal pins.

The invention and its practice will be further explained with reference to the accompanying drawings.

## Brief Description of the Drawings

Figure 1 is a view normal to the plane of a single-in-line device mounted to a sheet metal heatsink;

Figure 2 is a section to an enlarged scale on the line 2—2 in Figure 1; and

Figure 3 illustrates a practical way of forming the lug seen in Figure 2.

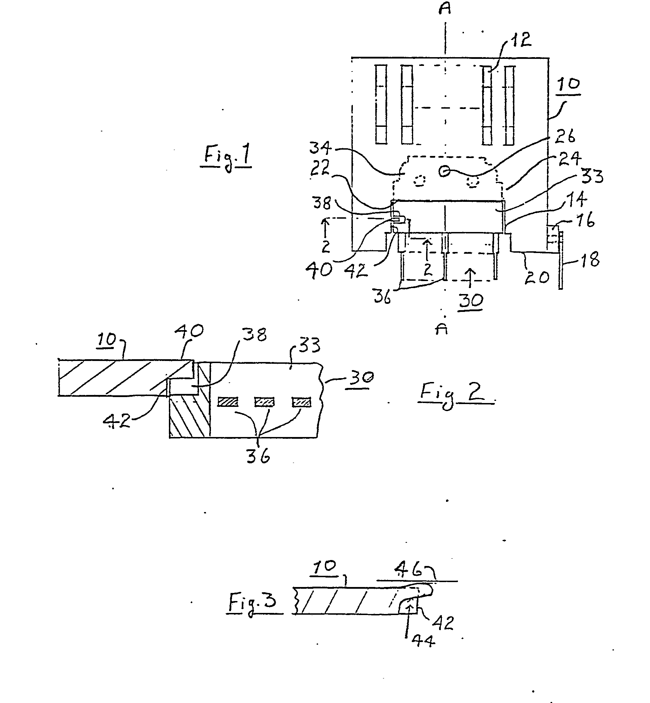

Referring to Figure 1, a heatsink 10 is formed of sheet metal. The upper portion of the heatsink is formed with, for example, louvres 12, one of many well established techniques for providing increased heat dissipating area. The bottom edge portion of the heatsink is formed with a generally rectangular recess 14 in which is located the rectangular casing of a single-in-line integrated circuit device 30. The heatsink illustrated is substantially planar but has at the lower edge a lug portion 16 bent up out of the plane of the figure and to which is staked a pin 18 that enters a hole in a printed circuit board for soldering thereto to independently support the heatsink the lower edge 20 of which abuts the board. The pin 18 can itself be soldered on the board. Alternatives such as the use of a depending finger from the lug are also possible. More than one pin or finger may be employed. Between the base 22 of the recess 14 and the louvres 12 is a flat, tab-receiving area 24 which is on the underside of the heatsink as seen in the drawing and in which is formed a tab-securing hole 26.

The construction thus far described is conventional for receiving a single-in-line device 30 whose casing 33 of moulded plastics for example seats in the recess 14. From one long edge of the casing extends a metal tab 34 providing a heat conductive path from the semiconductor substrate of the integrated circuit, that is secured to the area 24 with a hole in the tab aligned with the hole 26 so that the tab can be secured, as by a screw and nut or clip (not shown), to the area 24 in good thermal contact therewith. At the other long side of the casing project the device pins 36, say nine in number, of equal dimensions and spaced at equal pitch. The pins 36 project below the lower edge 20 of the heatsink for insertion in the printed circuit board.

The device 30 is symmetrical, as seen in the plane of the drawing, about the axis marked A—A which passes through the mounting hole in the tab, which also has other symmetrically disposed securing holes etc. shown. Consequently, it is possible in the arrangement thus far described for the device 30 to be reverse oriented, i.e. turned through 180°, and secured to the heatsink with the pins 36 in the reverse orientation to that required for correct connection on the board. The consequences of such wrong connection have already been mentioned.

It is conventional in integrated circuit devices of the kind being considered to put a notch or recess at one end of the casing in moulding the casing, the notch extending from one casing surface to almost half-way through the casing. Such a notch is shown at 38. The casing may have other moulding notches or recesses but not having the same characteristic which makes the recess clearly identifiable as an index from which to count the pin numbers, i.e. 1—9, in accord with the manufacturer's data on any particular device.

The notch 38 is taken advantage of to ensure correct orientation of the mounted device by providing a small lug 40 to project from the adjacent side 42 of heatsink recess 14 and enter the notch 38. This lug is better seen in the enlarged section of Figure 2. This shows that the metal thickness is about half that of the thickness of the device casing and that the lug is formed to be about half the metal thickness from the side adjacent notch 38 which extends to nearly the mid-plane of the casing, i.e. the plane of the tab and pins. The lug need not be made to close tolerance. It merely has to locate in the recess 38. If the device is reverse oriented it will be seen that the correct location of the device casing 32 in the heatsink recess is obstructed by the lug 40. In practice the dimensions of recess 14 are made to be a reasonably close fit to the dimensions of casing 33 so that the un-notched edge of the casing will be obstructed by the lug 40. Integrated circuit devices are made to various standard dimensions and the heatsinks manufactured accordingly.

Figure 3 shows diagrammatically how the lug 40 could be more practically made by a punching operation carried out by the tool forming other parts of the heatsink. The appropriate side edge 42 of recess 14 is punched at 44 to about half the metal thickness against a tool surface 46 causing the metal to hump to some extent but also splay out sideways.

The invention has been described in relation to a specific heatsink for a single-in-line integrated circuit device. It will be appreciated that the teaching is of general application where an integrated circuit device is of the kind that can be wrongly oriented with respect to the heatsink but has an index notch of the kind described. It will also be appreciated that the same heatsink construction is equally usable with other semiconductor devices, such as the arrays mentioned above, that are similarly encased or encapsulated. It is the package that is relevant, not the internal nature of the device. While the heatsink specifically described has been formed of sheet metal, the teachings of the invention may be equally applied to heatsinks formed in other ways, for example by extrusion.

## Claims

1. A heatsink (10) constructed to have mounted thereto a semiconductor device (30) of the type having a casing (33) in which there is a notch (38) providing an index for pin identification, characterised in that said heatsink (10) has a lug (40) positioned to enter said notch (38) when the device (30) is correctly oriented with respect to the heatsink (10) and to obstruct mounting of the device in a reverse orientation.

2. A heatsink as claimed in Claim 1 for use with an integrated circuit device of the kind in which a heat-conductive tab (34) and terminal pins (36) project in a common plane from opposite sides of the casing of the integrated circuit and said notch (38) is located at one end of the casing (33), and wherein the construction of the heatsink to receive such a device comprises:

a recess (14) in a lower edge portion of the heatsink to receive and locate the casing (33) with said notch (38) thereof adjacent a side edge (42) of the recess and the terminal pins (36) thereof projecting beyond the lower edge (20) of said heatsink;

an area (24) of said heatsink (10) extending from the base (22) of said recess (14) and contactable by said tab (34) to be in area contact therewith, and means (26) associated with said heatsink for use in securing the tab (34) to the heatsink (10); and

characterised by said lug (40) projecting into said recess (14) from said side edge (42) thereof.

3. A heatsink as claimed in Claim 2 characterised in that said lug (40) is integral with the portion of the heatsink defining said recess.

4. A heatsink as claimed in Claim 2 or 3 further characterised in that said heatsink further comprises means (18) depending below said lower edge portion for securing the heatsink to a printed circuit board independently of a device mounted to the heatsink.

5. A heatsink as claimed in any one of Claims 1 to 4 characterised in that said heatsink is constructed from sheet metal.

**Revendications**

1. Dissipateur de chaleur (10) conçu de façon à porter un dispositif semiconducteur (30) du type possédant un capot (33) dans lequel il existe une entaille (38) constituant un repère pour l'identification des broches, caractérisé en ce que ledit dissipateur de chaleur (10) possède une patte (40) disposée de manière à pénétrer dans ladite encoche (38) lorsque le dispositif (10) est correctement orienté par rapport au dissipateur de chaleur (10) et à faire obstacle au montage du dispositif dans une orientation inverse.

2. Dissipateur de chaleur selon la revendication 1, destiné à être utilisé avec un dispositif à circuit intégré du type dans lequel un volet (34) conducteur de la chaleur et des broches de connexion (36) font saillie dans un plan commun depuis des côtés opposés du capot du circuit intégré et ladite entaille (38) est disposée à une extrémité du capot (33), et où la structure du dissipateur de chaleur destiné à recevoir un tel dispositif comprend:

un évidement (14) ménagé dans une partie de bord inférieure du dissipateur de chaleur afin de recevoir et de positionner le capot (33) de manière que sa dite entaille (38) soit adjacente d'un bord latéral (42) de l'évidement et que ses broches de connexion (36) fassent saillie au-delà du bord inférieur (20) dudit dissipateur de chaleur;

une zone (24) dudit dissipateur de chaleur (10) partant depuis la base (22) dudit évidement (14) et pouvant être mise en contact avec ledit volet (34) de façon à former un contact de surface avec celui-ci et un moyen (26) associé audit dissipateur de chaleur pour être utilisé dans la fixation du volet (34) au dissipateur de chaleur (10); et caractérisé en ce que ladite patte (40) fait saillie dans ledit évidement (14) depuis son dit bord latéral (42).

3. Dissipateur de chaleur selon la revendication 2, caractérisé en ce que ladite patte (40) est solidaire de la partie du dissipateur de chaleur définissant ledit évidement.

4. Dissipateur de chaleur selon la revendication 2 ou 3, caractérisé en outre en ce que ledit dissipateur comprend aussi un moyen (18) faisant saillie au-dessous de ladite partie de bord inférieure pour fixer le dissipateur de chaleur à une plaquette de circuit intégré indépendamment du dispositif monté sur la dissipateur de chaleur.

5. Dissipateur de chaleur selon l'une quelconque des revendications 1 à 4, caractérisé en ce que ledit dissipateur de chaleur est constitué d'une tôle métallique.

**Patentansprüche**

1. Wärmeableitvorrichtung (10), die zur Anbringung einer Halbleitervorrichtung (30) der Art ausgestaltet ist, die ein Gehäuse (33) aufweist, in dem eine Raste (38) vorgesehen ist, die einen Index für eine Stiftidentifikation bildet, dadurch gekennzeichnet, daß die Wärmeableitvorrichtung (10) eine Fahne (40) aufweist, die so angeordnet ist, daß sie in die Raste (38) eingreift, wenn die Vorrichtung (30) richtig bezüglich der Wärmeableitvorrichtung (10) ausgerichtet ist, und die ein Einsetzen der Vorrichtung in einer umgekehrten Richtung behindert.

2. Wärmeableitvorrichtung nach Anspruch 1 zur Verwendung mit einer integrierten Schaltungsvorrichtung der Art, bei der eine wärmeleitende Lasche (34) und Anschlußstifte (36) sich in einer gemeinsamen Ebene von entgegengesetzten Seiten des Gehäuses der integrierten Schaltung erstrecken und die Raste (38) an dem einen Ende des Gehäuses (33) angeordnet ist und wobei der Aufbau der Wärmeableitvorrichtung zur Aufnahme einer derartigen Vorrichtung aufweist:

eine Ausnehmung (14) im Bereich einer unteren Kante der Wärmeableitvorrichtung zur Aufnahme und Unterbringung des Gehäuses (33), wobei die genannte Raste (38) desselben zu einer Seitenkante (42) der Ausnehmung benachbart ist und deren Anschlußstifte (36) sich über die untere Kante (20) der Wärmeableitvorrichtung hinaus erstrecken;

eine Fläche (24) der Wärmeableitvorrichtung (10), die sich von der Grundlinie (22) der Ausnehmung (14) erstreckt und durch die Lasche (34) kontaktiert werden kann, damit ein Flächenkontakt vorhanden ist, und eine Vorrichtung (26) die der Wärmeableitvorrichtung zur Verwendung bei der Befestigung der Lasche (34) an der Wärmeableitvorrichtung (10) zugeordnet ist; und dadurch gekennzeichnet, daß die Fahne (40) sich in die Ausnehmung (14) von ihrer Seitenkante (42) her erstreckt.

3. Wärmeableitvorrichtung nach Anspruch 2, dadurch gekennzeichnet, daß die Fahne (40) einstückig ist, mit demjenigen Teil der Wärmeableitvorrichtung, der die Ausnehmung definiert.

4. Wärmeableitvorrichtung nach Anspruch 2 oder 3, ferner dadurch gekennzeichnet, daß die Wärmeableitvorrichtung ferner eine Vorrichtung (18) aufweist, die sich bis unter den Unterkantenbereich erstreckt und zum Befestigen der Wärmeableitvorrichtung an einer gedruckten Schaltungsplatte unabhängig davon dient, daß eine Vorrichtung an der Wärmeableitvorrichtung angebracht ist.

5. Wärmeableitvorrichtung nach einem der Anspruch 1 bis 4, dadurch gekennzeichnet, daß die Wärmeableitvorrichtung aus Blech hergestellt ist.

_Fig.1_

_Fig 2_

_Fig.3_